Europäisches Patentamt.

European Patent Office

Office européen des brevets

(11) Publication number: **0 123 795**
**B1**

## EUROPEAN PATENT SPECIFICATION

(45) Date of publication of patent specification: 02.05.90

(51) Int. Cl.⁵: **H 01 L 23/36, H 01 L 23/46**

(21) Application number: 84101103.4

(22) Date of filing: 03.02.84

(54) Unitary heat sink for an electronic device module.

(30) Priority: 29.04.83 US 489875

(43) Date of publication of application:
07.11.84 Bulletin 84/45

(45) Publication of the grant of the patent:
02.05.90 Bulletin 90/18

(84) Designated Contracting States:
DE FR GB IT

(56) References cited:
EP-A-0 029 501

IBM TECHNICAL DISCLOSURE BULLETIN, vol.
25, no. 4, September 1982, pages 1841,1842,
New York, US; R.M. DUNN et al.: "Adhesive-
metal shim module capping technique"

IBM TECHNICAL DISCLOSURE BULLETIN, vol.
26, no. 7A, Decmeber 1983, pages 3233,3234,
New York, US; J.L. HORVATH et al.: "Metal
cooling fins for a semiconductor package"

(73) Proprietor: International Business Machines
Corporation
Old Orchard Road
Armonk, N.Y. 10504 (US)

(72) Inventor: Horvath, Joseph Louis
4 Victor Lane
Poughkeepsie, N.Y. 12601 (US)

(74) Representative: Schröder, Otto H., Dr. Ing. et al
IBM Corporation Säumerstrasse 4
CH-8803 Rüschlikon (CH)

(56) References cited:

IBM TECHNICAL DISCLOSURE BULLETIN, vol.
22, no. 6, November 1979, pages 2297,2298,
New York, US; A.J. ARNOLD et al.: "Heat sink
design for cooling modules in a forced air
environment"

IBM TECHNICAL DISCLOSURE BULLETIN, vol.
23, no. 2, July 1980, pages 603,604, New York,
US; J.L. HORVATH: "Cooling fin structure"

# Description

This invention relates generally to heat transfer mechanisms and more particularly to an improved heat transfer mechanism for removing the heat generated in an electronic circuit module assembly. The invention concerns a unitary heat sink for an electronic device module having a substrate with a plurality of electronic devices operatively mounted thereon, and a lid element mounted on the substrate forming an enclosure for the electronic devices. Also provided is a process for producing such a unitary heat sink.

The high circuit densities in modern integrated circuit semiconductor devices require that the heat generated by their operation be efficiently removed in order to maintain the temperature of the devices within limits that will keep the operating parameters of the devices within predetermined ranges, and also prevent destruction of the device by overheating. The problems associated with heat removal are increased when the device is connected to the supporting substrate with solder terminals that electrically connect the device to appropriate terminals on the substrate as compared to a back bonded device where the support substrate acts as a heat sink. On such solder bonded devices, the heat transfer that can be accomplished through the solder bonds is limited, as compared to back bonded devices. Ordinarily the semiconductor devices are contained in an enclosure and the devices are mounted in or in contact with a heat sink. The heat sink can be cooled with liquid or air. However, when cooling requirements can be met, it is normally less expensive to dissipate the heat with a flow of air, which can chilled, if desired.

As the size of the substrate supporting the operating device increases, the more significant differences in coefficients of expansion of the materials of the elements of the semiconductor package become. During use the temperature of the package is inherently cycled. Thus when the support substrate is made of ceramic, the lid or enclosure over the devices is also preferably made of ceramic with a corresponding coefficient of expansion. However, ceramic does not conduct heat as well as metal. Therefore, cooling fins formed of ceramic are relatively inefficient when compared to metal and may not be suitable to meet the requirements. Individual metal fins can be bonded to the ceramic to overcome the coefficient of expansion difference problems. However, the finned lid is fragile and relatively expensive because of the tedious and time-consuming operation of individually bonding the fins. A large unitary fin assembly can be bonded to the lid surface. However, since the coefficient of expansion of metal and ceramic are quite dissimilar either the fins and lids will separate, and/or the assembly would bow when heated. At the very least, stresses are generated which can be detrimental to the reliability over the life of the package.

The following prior art references are representative of the start of the art:

U.S. 4,277,816 discloses a cooling system for a semiconductor package where a plurality of individual slotted hollow metal tubes are mounted by brazing or soldering, on the lid that encloses semiconductor devices. A blower and a baffled chamber are provided to provide impingement cooling of the packages, i.e., air is directed axially into the tube mounted on the lid.

U.S. 4,296,455 describes an impingement cooling system employing an individual hollow stud heat sink arrangement. The studs are individually bonded to a ceramic cover and not connected into a unitary assembly.

IBM Technical Disclosure Bulletin, Vol. 23, No. 2, July 1980, p. 603, shows a cooling fin structure formed of individual serpentine shaped fins bonded to a ceramic cap.

IBM Technical Disclosure Bulletin, Vol. 22, No. 6, November 1979, p. 2297, discloses a unitary heat sink design adapted for impingement cooling. The cooling studs are not hollow and are rigidly connected through the heat sink body.

IBM Technical Disclosure Bulletin, Vol. 25, No. 4, September 1982, p. 1841, shows a heat sink design in which serpentine shaped fins are connected to form a unitary structure. The multi-leg structure and the particular connection of adjacent fins of the current invention are not disclosed.

None of the heat sink arrangements described in the above references has, in practice, been entirely satisfactory in overcoming the problems caused by the differences in coefficients of expansion without requiring time-consuming fabrication steps. It is thus a principle object of the present invention to provide a heat transfer mechanism for a large scale integrated circuit module that will provide efficient heat removal and which is compatible with ceramic materials.

A more specific object of the invention is to provide an effective and efficient metal heat sink for mounting on ceramic lids that can be thermally cycled without imposing destructive or harmful stresses on the lid.

The invention as claimed is intended to accomplish these objectives and to remedy the drawbacks of hitherto known structures. The advantages offered by the invention are mainly that the hereinafter described unitary heat sink assembly provides, due to the hollow mulit-leg fins and their particular connections, for great flexibility and insensitivity to temperature effects caused by different expansion coefficients of the heat sink material and that of the lid of the semiconductor device module, and that the structure is easy to fabricate.

One way of carrying out the invention is described in detail below with reference to drawings which illustrate one specific embodiment, and in which:

Fig. 1 is a perspective view, partially in section, of an integrated circuit module system in which the fin heat sink structure of the invention is employed.

Fig. 2 is a top view illustrating a preferred specific embodiment of the heat sink structure of the invention.

Fig. 3 is a perspective view of the heat sink structure of the invention.

Fig. 4 is another perspective view of the heat sink structure of the invention showing the bottom surface which, in operation, is bonded to the lid of a semiconductor package.

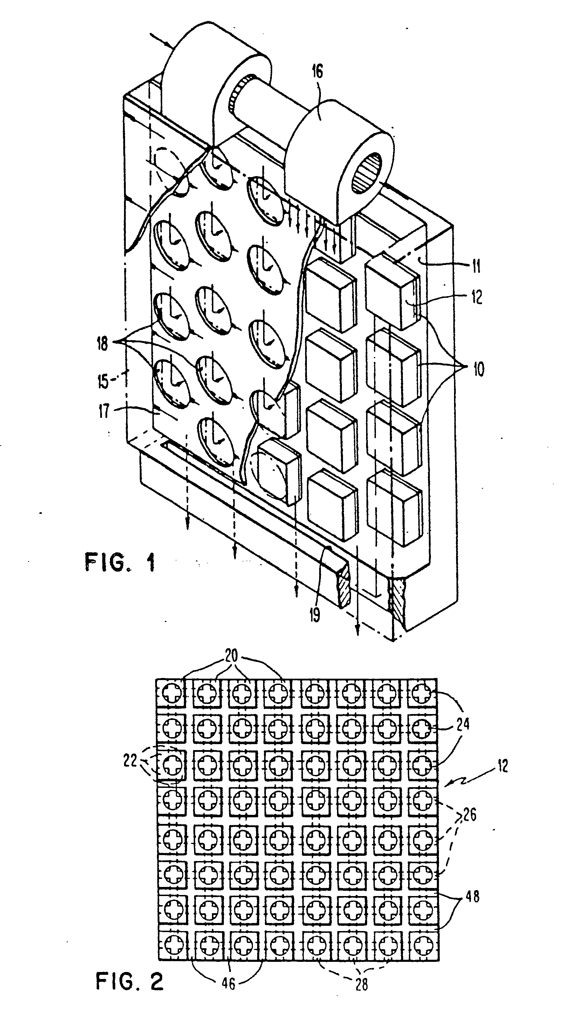

Referring to Fig. 1, an air cooling system for high density integrated circuit modules for utilizing the heat sink of the invention is schematically illustrated.

Large scale integrated circuit chips (not shown) are packaged in modules 10. The modules are in turn supported by printed circuit board 11. The modules 10 each have a heat conductive covering surface and attached to this covering surface is a unitary slotted heat sink element 12. An air plenum 15 is spaced a suitable distance from the top surface of the integrated circuit module. Associated with the air plenum chamber 15 is an air moving device 16. Internal to the air plenum 15 in the surface 17 facing the integrated circuit board assembly of modules are a plurality of openings 18. Under each opening 18 is preferably a module 10 having the unitary heat sink 12 of the invention mounted thereon. In the base of the assembly beneath the air plenum 15 and the circuit board 11 is a slit 19 which permits the exhausted air to be exited from the air cooling system.

Referring now to Figs. 2—4 of the drawings, there is illustrated a preferred specific embodiment of the unitary heat sink embodiment 12 of the invention. Heat sink 12 is adapted to be bonded directly to the surface of a heat generating body, more preferably the lid of a semiconductor package, wherein heat must be dissipated. The heat sink structure permits bonding directly to materials having a dissimilar coefficient of expansion since the bonding surface is broken up into a plurality of small surfaces that are free to move or flex to the degree necessary for adjusting to the expansion and contraction of the surface to which it is bonded.

Heat sink 12 has a plurality of upstanding cooling fin elements 20 that are hollow. Each fin has four upstanding leg portions 22 that are joined at the top of the fin 20. The leg portions 22 are capable of flexing to accommodate for expansion and contraction of the surface that the heat sink 12 is bonded to, as will be explained and illustrated in more detail. The leg portions 22 are preferably formed by the intersection of two slots 26 and 28. A hole 24 is provided in the top portion of each cooling fin when impingement cooling, in the combination in Fig. 1, is used for dissipating heat. The hole 24 extends downwardly to at least the slots 26 and 28 providing a passage through the fin with openings in the lower portion to allow cooling medium to flow downwardly and outwardly. This flow of fluid, normally air, provides effective heat dissipation. Turbulence is caused by air flowing outwardly about the four leg portions 22 after entering top opening 24, which dispels the boundary air layer that normally would impede heat transfer.

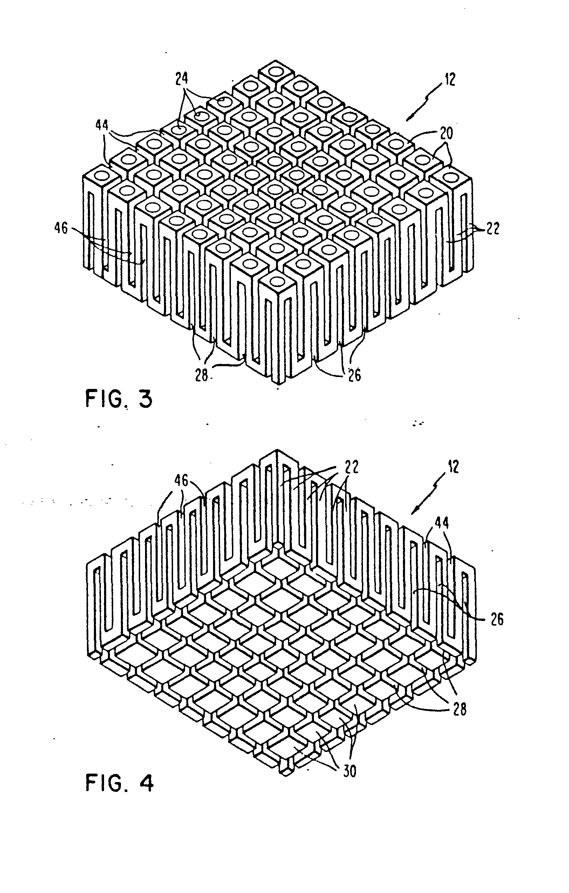

As shown more clearly in Fig. 4, heat sink 12 has a plurality of square flat base portions 30 which, in use, are bonded to the body to be cooled. In the preferred embodiment, the portions 30 are square, but could be rectangular or round as well. The base portions 30 are attached to the cooling elements 20 but in a very special manner. The leg portions 22 of the cooling fin elements 20 are each attached to a different but adjacent base portion 30. Each base portion 30 is thus attached to four different fin elements. The adjacent corners of four base portions 30 thus support a single fin element. Thus, any relative movement of the individual base portions 30, due to heating or cooling effects, is absorbed by flexing of the leg portions 22 of the fin elements. The heat sink structure is unitary because the base portions 30 are all tied together by the upper portions of the cooling fins 20. In addition the large area of base portions 30 provide effective thermal transfer of heat to the heat fins 20. Furthermore, a hot spot, caused as for example by an active semiconductor device, beneath a base portion 30 results in transfer of heat to four separate heat fins which reduces thermal resistance and also promote a more uniform temperature profile in the heat generating body.

As is obvious from Fig. 4, the base portions 30 that support the fin elements along the edges of the heat sink 12 are approximately one-half the size of the centrally located base portions 30. This is necessary because the outside row of base portions are required to secure the leg portions of only two fin elements.

The heat sink can be made of any suitable material having a thermal conductivity sufficient to meet the demands of the particular application. However, metals are preferred. Preferred metals are copper and aluminium. The heat sink can be bonded to the heat generating body by any suitable technique, as for example, by brazing or soldering. As previously mentioned, the support element, i.e. the lid of a semiconductor package, need not have a coefficient of expansion that matches the material of the heat sink. It is frequently desirable, particularly in larger semiconductor modules, to use a ceramic lid when the substrate is formed of ceramic. Material expansion mismatch between the material of the heat generating body is effectively reduced by reducing the size of the bonding interface, i.e. by breaking the area of the base portion of the heat sink into small individual areas that are free to move relative to one another.

The unitary heat sink of the invention can be fabricated by the method which will now be described. It will be apparent that the relatively complex and intricate heat sink structure can be fabricated by performing a number of simple routine machining operations. In forming the heat sink a solid rectangular or square block of material having the desired size is selected. A first plurality of parallel spaced slots 26, as most clearly shown in Fig. 4, is machined in the bottom of the selected block. The depth of the slots is obviously less than the thickness of the block itself. A second plurality of parallel spaced slots 28 that are transverse to slots 26 is subsequently machined in the bottom of the block. This forms the surface configurations of base portions 30 that serves as the bonding interface. A third plurality of slots 44, positioned between slots 26 which overlap in the block, are machined in the top opposite side of the block. Subsequently, a fourth plurality of parallel slots 46 are machined from the top of the block which are positioned between slots 28 and are also in overlapping relation. These slots 44 and 46 form the exterior shape of the cooling fin elements 20. Holes 24 are drilled from the top of the block to open the fins for impingement cooling.

As most clearly shown in Fig. 4 slots 44 and 46 from the top of the block shape the exterior surface of the fins 20. Slots 26 and 28 from the bottom of the block form the base portions 30 of the fins and also shape the leg portions 22.

The heat sink of the invention can be fabricated in any other suitable manner, as for example by casting. If the heat sink is cast, the slots 26, 28, 44 and 46 can be slightly tapered to facilitate removal of the heat sink 12 from the mold. The depth of the slots and the height of the cooling fin elements can be varied to meet the requirements of the specific application. In general, the width of slots 26 and 28 constitutes approximately 1/3 to 1/2 of the total width of the fin elements 20. The relative dimensions of the slots 26 and 28 to the overall height of the cooling fin elements 20 determines the cooling effectiveness and capacity of the structure. Preferably the ratio of the height of the cooling element 20 to the width of slots 26 or 28 is the range of 5 to 50.

## Claims

1. Unitary heat sink for an electronic device module (10) having a substrate with a plurality of electronic devices operatively mounted thereon, and a lid element mounted on the substrate forming an enclosure for the electronic devices, the heat sink (12), being formed of heat conducting material bonded to the lid element for dissipating heat generated by the electronic devices, the heat sink having a plurality of cooling fin elements (20) of an essentially square or rectangular cross-section, and positioned orthogonally relative to the top surface of the lid, the fin elements having elongated upwardly extending openings that terminate short of the top of the fin elements and which divide the base of the fin elements into leg sections which are supported by flat quadrilateral base portions individually bonded to the lid, characterized in that

—the fin elements (20) are arranged in columns and rows, forming a 2-dimensional array,

—the elongated upwardly extending openings (26, 28) are provided in each of the vertical walls of the fin elements thereby dividing the base of each of the fin elements into four leg sections positioned at the corners of the fin elements, and in that

—the quadrilateral base portions (30) are arranged in columns and rows, forming a 2-dimensional array, the four individual leg sections of each fin element being connected to four different adjacent quadrilateral base portions, whereby, in turn, each base portion is attached to four different fin elements.

2. The unitary heat sink of claim 1 wherein each of the cooling fin elements (20) is provided with an opening (24) in the top end which permits downward flow of a cooling medium through the fin elements and exiting outwardly through the elongated upwardly extending openings.

3. The unitary heat sink of claim 2 wherein the heat conductive material is a metal.

4. The unitary heat sink of claim 3 wherein the heat conductive material is aluminium.

5. The unitary heat sink of claim 1 wherein the ratio between the height dimension of the cooling fin elements (20) and the width of the upwardly extending openings (26, 28) is in the range of 5 to 50.

6. The unitary heat sink of claim 1 wherein the four leg sections are formed by the intersection of two transverse slots (26, 28), where the width of the slots (26, 28) is from 1/3 to 1/2 of the total horizontal width of the fin elements (20).

7. A process for producing a unitary heat sink, such as claimed in claim 1, for an electronic device module (10) having a substrate with a plurality of electronic devices operatively mounted thereon, and a lid element mounted on the substrate forming an enclosure for the electronic devices, the process comprising the steps of

providing a rectangular block of heat conducting material,

forming a plurality of first parallel spaced slots (26) in the bottom of the block in a first direction,

forming a plurality of second parallel spaced slots (28) in the bottom of the block in a second direction that is transverse to the first direction,

forming a plurality of third parallel spaced slots (44) in the top of the block in said first direction that are positioned between and in overlapping relation to the first spaced slots (26),

forming a plurality of fourth parallel spaced slots (46) in the top of the block in said second direction that are positioned between and in overlapping relation to the second spaced slots (28), and

forming openings (24) in the top surface of each of the resultant cooling fin elements (20) formed by the plurality of the third (44) and fourth (46) slots.

## Patentansprüche

1. Einteiliger Wärmeableiter für ein elektrisches Modul (10) mit einem Substrat, auf dem eine Mehrzahl von elektronischen Bauteilen angeordnet ist, und mit einer Abdeckplatte, die auf dem Substrat befestigt ist und ein Gehäuse für die

elektronischen Bauteile bildet, wobei der Wärmeableiter, bestehend aus einem wärmeleitenden Material, mit der Abdeckplatte zwecks Ableitung der durch die elektronischen Bauteile erzeugten Wärme verbunden ist und eine Mehrzahl von Kühlelementen (20) mit im wesentlichen quadratischem oder rechteckigem Querschnitt aufweist, die senkrecht zur Oberfläche der Abdeckplatte angeordnet sind und längliche, vertikal ausgerichtete Öffnungen aufweisen, welche bis kurz unter das obere Ende der Kühlelemente reichen und die Basis der Kühlelemente in Fussteile aufteilen, die von flachen viereckigen Basisplatten getragen werden, die individuell mit der Abdeckplatte verbunden sind, dadurch gekennzeichnet, dass

—die Kühlelemente (20) in Kolonnen und Reihen angeordnet sind und eine 2-dimensionale Anordnung bilden,

—die länglichen, vertikal ausgerichteten Öffnungen (26, 28) in jeder der vier vertikalen Wände der Kühlelemente vorhanden sind, wodurch die Basis jedes der Kühlelemente in vier Fussteile aufgeteilt wird, die sich an den Ecken der Kühlelemente befinden, und dass

—die viereckigen Basisplatten (30) in Kolonnen und Reihen angeordnet sind und eine 2-dimensionale Anordnung bilden, derart, dass die vier individuellen Fussteile jedes Kühlelements mit vier verschiedenen, benachbarten viereckigen Basisplatten verbunden sind, wodurch andererseits jede Basisplatte mit vier verschiedenen Kühlelementen verbunden ist.

2. Der einteilige Wärmeableiter nach Anspruch 1, bei welchem jedes der Kühlelemente (20) in der oberen Oberfläche eine Öffnung (24) aufweist, die einen abwärts gerichteten Fluss eines Kühlmittels durch das Kühlelement mit seitlichem Austritt durch die länglichen, vertikal ausgerichteten Öffnungen ermöglicht.

3. Der einteilige Wärmeableiter nach Anspruch 2, bei welchem das wärmeleitende Material ein Metall ist.

4. Der einteilige Wärmeableiter nach Anspruch 3, bei welchem das wärmeleitende Material aus Aluminium besteht.

5. Der einteilige Wärmeableiter nach Anspruch 1, bei welchem das Verhältnis der Höhe der Kühlelemente (20) zur Breite der vertikal ausgerichteten Öffnungen (26, 28) zwischen 5 und 50 beträgt.

6. Der einteilige Wärmeableiter nach Anspruch 1, bei welchem die vier Fussteile durch zwei sich kreuzende, zueinander rechtwinklig verlaufende Einschnitte (26, 28) gebildet werden, wobei die Breite der Einschnitte (26, 28) zwischen 1/3 und 1/2 der gesamten horizontalen Breite der Kühlelemente (20) liegt.

7. Ein Verfahren zur Herstellung eines einteiligen Wärmeableiters wie in Anspruch 1 beansprucht für eine elektrisches Modul (10) mit einem Substrat, auf dem eine Mehrzahl von elektronischen Bauteilen angeordnet ist, und mit einer Abdeckplatte, die auf dem Substrat befestigt ist und ein Gehäuse für die elektronischen Bauteile bildet, das die folgenden Prozessschritte beinhaltet:

Bereitstellen eines rechteckigen Blocks aus wärmeleitfähigem Material;

Anbringen einer Mehrzahl erster paralleler Einschnitte (26) in die Unterseite des Blocks in einer ersten Richtung;

Anbringen einer Mehrzahl zweiter paralleler Einschnitte (28) in die Unterseite des Blocks in einer zweiten Richtung, die zur ersten Richtung im rechten Winkel liegt;

Anbringen einer Mehrzahl dritter paralleler Einschnitte (44) in die Oberseite des Blocks in der ersten Richtung, wobei diese Einschnitte zwischen den ersten Einschnitten (26) liegen und sich mit diesen überlappen;

Anbringen einer Mehrzahl vierter paralleler Einschnitte (46) in die Oberseite des Blocks in der zweiten Richtung, wobei diese Einschnitte zwischen den zweiten Einschnitten (28) liegen und sich mit diesen überlappen, und

Erstellen von Öffnungen (24) in der oberen Oberfläche jedes der resultierenden Kühlelemente (20), die durch die dritten (44) und vierten (46) Einschnitte gebildet werden.

## Revendications

1. Dissipateur de chaleur unitaire pour un module de dispositifs électroniques (10) ayant un substrat sur lequel est montée opérativement une pluralité de dispositifs électroniques, et un élément de couvercle monté sur le substrat et qui forme un boîtier pour les dispositifs électroniques,

le dissipateur de chaleur (12) étant formé d'un matériau conducteur de chaleur lié à l'élément de couvercle pour dissiper la chaleur produite par les dispositifs électroniques, le dissipateur de chaleur ayant une pluralité d'éléments d'ailettes de refroidissement (20) de section essentiellement carrée ou rectangulaire et placés de façon orthogonale par rapport à la surface supérieure du couvercle, les éléments d'ailettes comprenant des ouvertures allongées s'étendant vers le haut qui se terminent près du sommet des éléments d'ailettes et qui divisent la base des éléments d'ailettes en parties de bras qui sont portées par des parties de base plates quadrilatérales liées de façon individuelle au couvercle, caractérisé en ce que:

—les éléments d'ailettes (20) sont agencés en colonnes et en rangées, en formant un réseau à 2 dimensions,

—les ouvertures allongées s'étendant vers le haut (26, 28) sont prévues dans chacune des parois verticales des éléments d'ailettes en divisant ainsi la base de chacun des éléments d'ailettes en quatre parties de bras situées aux coins des éléments d'ailettes, et en ce que:

—les parties de base quadrilatérales (30) sont agencées en colonnes et en rangées, en formant un réseau à 2 dimensions, les quatre parties de bras individuelles de chaque élément d'ailette étant connectées à quatre parties de base quadrilatérales différentes adjacentes, d'où il résulte que chaque partie de base est elle-même fixée à quatre éléments d'ailettes différents.

2. Dissipateur de chaleur unitaire selon la revendication 1, dans lequel chacun des éléments d'ailettes de refroidissement (20) est muni d'une ouverture (24) dans l'extrémité supérieure qui autorise un écoulement vers le bas d'un milieu de refroidissement au travers des éléments d'ailettes et la sortie vers l'extérieur au travers des ouvertures allongées s'étendant vers le haut.

3. Dissipateur de chaleur unitaire selon la revendication 2, dans lequel le matériau conducteur de chaleur est un métal.

4. Dissipateur de chaleur unitaire selon la revendication 3, dans lequel le matériau conducteur de chaleur est de l'aluminium.

5. Dissipateur de chaleur unitaire selon la revendication 1, dans lequel le rapport entre la dimension de hauteur des éléments d'ailettes de refroidissement (20) et la largeur des ouvertures s'étendant vers le haut (26, 28) est dans la gamme de 5 à 50.

6. Dissipateur de chaleur unitaire selon la revendication 1, dans lequel les quatre parties de bras sont formées par l'intersection de deux fentes transverses (26, 28) où la largeur des fentes (26, 28) vaut entre 1/3 et 1/2 de la largeur horizontale totale des éléments d'ailettes (20).

7. Procédé pour produire un dissipateur de chaleur unitaire tel que revendiqué dans la revendication 1 pour un module de dispositifs électroniques (10) ayant un substrat sur lequel est montée opérativement une pluralité de dispositifs électroniques, et un élément de couvercle monté sur le substrat et qui forme un boîtier pour les dispositifs électroniques, le procédé comprenant les étapes suivantes:

prévoir un bloc rectangulaire en un matériau conducteur de chaleur,

former une pluralité de premières fentes séparées parallèles (26) dans la partie inférieure du bloc selon une première direction,

former une pluralité de deuxièmes fentes séparées parallèles (28) dans la partie inférieure du bloc selon une deuxième direction qui est transverse à la première direction,

former une pluralité de troisièmes fentes séparées parallèles (44) dans la partie supérieure du bloc selon ladite première direction qui sont placées entre les premières fentes séparées (26) en relation de chevauchement,

former une pluralité de quatrièmes fentes séparées parallèles (46) dans la partie supérieure du bloc selon ladite deuxième direction qui sont placées entre les deuxièmes fentes séparées (28) en relation de chevauchement, et

former des ouvertures (24) dans la surface supérieure de chacun des éléments d'ailettes de refroidissement résultants (20) formés par la pluralité des troisièmes (44) et quatrièmes (46) fentes.

EP 0 123 795 B1

FIG. 1

FIG. 2

1

FIG. 3

FIG. 4